(19) Europäisches Patentamt / European Patent Office / Office européen des brevets

(11) **EP 3 081 949 B1**

(12) **FASCICULE DE BREVET EUROPEEN**

(45) Date de publication et mention
de la délivrance du brevet:
**22.09.2021   Bulletin 2021/38**

(51) Int Cl.:
**G01R 22/06** (2006.01)

(21) Numéro de dépôt: **16164995.9**

(22) Date de dépôt: **13.04.2016**

(54) **PROCÉDÉ DE DÉTECTION DE FRAUDES DANS UN RÉSEAU DE FOURNITURE D'ÉLECTRICITÉ**

**VERFAHREN ZUR ERKENNUNG VON BETRÜGERISCHEN HANDLUNGEN IN EINEM STROMVERSORGUNGSNETZ**

**METHOD FOR DETECTING FRAUD IN AN ELECTRICITY SUPPLY NETWORK**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **14.04.2015   FR 1553222**

(43) Date de publication de la demande:
**19.10.2016   Bulletin 2016/42**

(73) Titulaire: **SAGEMCOM ENERGY & TELECOM SAS**
**92500 Rueil-Malmaison (FR)**

(72) Inventeur: **TEBOULLE, Henri**
**92500 RUEIL MALMAISON (FR)**

(74) Mandataire: **Cabinet Le Guen Maillet**
**3, impasse de la Vigie**
**CS 71840**
**35418 Saint-Malo Cedex (FR)**

(56) Documents cités:
**WO-A1-2014/129058     WO-A2-2006/044035**
**US-A1- 2010 134 089**

• **FOURIE J W ET AL: "A statistical method to minimize electrical energy losses in a local electricity distribution network", AFRICON, 2004. 7TH AFRICON CONFERENCE IN AFRICA GABORONE, BOTSWANA SEPT. 15-17, 2004, PISCATAWAY, NJ, USA,IEEE, vol. 2, 15 septembre 2004 (2004-09-15), pages 667-673, XP010780534, DOI: 10.1109/AFRICON.2004.1406768 ISBN: 978-0-7803-8605-1**

**Description**

La présente invention concerne un procédé de détection de fraude dans un réseau de fourniture d'électricité comprenant une pluralité de compteurs électriques reliés à un concentrateur de données par des câbles d'alimentation électrique et un dispositif mettant en œuvre le procédé.

Les communications par courants porteurs en ligne CPL (« PowerLine Communications (PLC) » en terminologie anglo-saxonne) se développent, notamment dans le cadre des réseaux d'alimentation électrique de type AMM (Gestion de mesure automatique, « Automated Meter Management » en terminologie anglo-saxonne). Des réseaux de communication sont ainsi implémentés au-dessus de réseaux d'alimentation électrique pour la collecte automatisée, auprès de compteurs électriques intelligents (« smart meters » en anglais), de données de relevés de consommation énergétique. Les communications par courants porteurs utilisent, par exemple, des protocoles de communication tels que le protocole G3-PLC (CPL de troisième génération: « Third Generation PLC » en terminologie anglo-saxonne. ITU-T G.9903) ou PRIME (Evolution des mesures intelligentes par courant porteur, « PoweRline Intelligent Metering Evolution » en terminologie anglo-saxonne).

De tels réseaux CPL peuvent avoir une forme d'arbre pour permettre d'étendre la portée des communications. C'est le cas par exemple dans les réseaux CPL utilisant le protocole PRIME ou le protocole G3-PLC. Les dispositifs de tels réseaux CPL sont généralement appelés *nœuds.* Un dispositif nœud, dit concentrateur de données, tient le rôle de racine du réseau CPL et gère le réseau CPL de manière à organiser le partage d'un même support de communication : émission de balises de synchronisation, gestion de topologie... Des dispositifs nœuds, généralement des compteurs électriques intelligents, servent alors de relais pour le compte d'autres dispositifs nœuds du réseau CPL, i.e. d'autres compteurs électriques intelligents, lorsque ces derniers n'arrivent pas à recevoir directement des informations du concentrateur de données, et à transmettre directement des informations au concentrateur de données. On dit alors que le réseau de communication est hiérarchisé.

Plusieurs relais peuvent ainsi être nécessaires pour permettre à un dispositif nœud de communiquer avec le concentrateur de données. Un premier dispositif nœud servant de relais pour le compte d'un second dispositif nœud est qualifié de *parent,* alors que, dans cette relation inter-nœud, le second dispositif nœud est qualifié d'*enfant.* On dit aussi que le second dispositif nœud est rattaché au premier dispositif nœud.

Un compteur électrique, qu'il soit intelligent ou pas, est utilisé principalement pour mesurer une consommation électrique d'une installation électrique. Il est connu que certains utilisateurs d'une installation électrique mettent en œuvre des fraudes afin de diminuer la mesure de consommation électrique réalisée par le compteur électrique supervisant leur installation électrique. Des méthodes de détection de fraudes peuvent être implémentées directement dans les compteurs électriques. Or, un opérateur de fourniture d'électricité gère généralement un nombre très important de compteurs électriques. Par conséquent, ces méthodes peuvent être compliquées et coûteuses à déployer, car elles peuvent nécessiter des modifications de chaque compteur électrique. Par ailleurs, ces méthodes sont systématiques, i.e. chaque compteur électrique est modifié même si aucune fraude n'est mise en œuvre, et ne permettent pas de cibler une partie du réseau électrique dans laquelle des fraudes sont réellement mises en œuvre.

Il est souhaitable de pallier ces différents inconvénients de l'état de la technique.

Il est notamment souhaitable de proposer une méthode permettant de cibler des parties d'un réseau électrique dans lesquelles des fraudes sont mises en œuvre.

Il est notamment souhaitable de fournir une solution qui soit simple à mettre en œuvre et à faible coût.

Des documents pertinents de l'état de la technique sont WO 2014/129058 A1, WO 2006/044035 A2, FOURIE J W ET AL: "A statistical method to minimize electrical energy losses in a local electricity distribution network", AFRICON, 2004. 7TH AFRICON CONFERENCE IN AFRICA GABORONE, BOTSWANA SEPT. 15-17, 2004, PISCATAWAY, NJ, USA,IEEE, vol. 2, 15 septembre 2004 (2004-09-15), pages 667-673 et US 2010/134089 A1.

Selon un premier aspect de la présente invention, la présente invention concerne un procédé de détection de fraudes dans un réseau de fourniture d'électricité selon la revendication 1.

Le procédé permet donc de détecter une fraude dans un réseau de fourniture d'électricité à distance sans modifier chaque compteur électrique du réseau.

Selon un mode de réalisation, lors de la comparaison, un ratio résultant d'une division de l'énergie cumulée $E_\Sigma$ par l'énergie globale $E_{DC}$ est comparé à une valeur de seuil prédéfinie, une fraude étant détectée lorsque ledit ratio est inférieur à la valeur de seuil prédéfinie.

Selon un mode de réalisation, l'énergie mesurée globale $E_M^g$ et l'énergie perdue en ligne globale $E_P^g$ sont calculées à partir d'informations transmises par lesdits compteurs électriques au concentrateur de données en utilisant des communications par courant porteur en ligne via le réseau de fourniture d'électricité.

L'utilisation de classes permet de simplifier l'estimation de l'énergie perdue en ligne globale $E_P^g$.

Selon un mode de réalisation, chaque classe *k* est associée en outre à un niveau de hiérarchie, une première classe associée à une première plage ayant un niveau de hiérarchie inférieur à une deuxième classe associée à une deuxième plage lorsque la première plage est représentative d'éloignements inférieurs aux éloignements représentés par la seconde plage, et en ce que l'estimation de l'énergie perdue en ligne de chaque classe *k* comprend : calculer une intensité cumulée $I_k$ pour la classe *k*, l'intensité cumulée $I_k$ étant une somme d'intensités moyennes de courants électriques reçus par et provenant de chaque compteur électrique de ladite classe *k* pendant la période prédéfinie ; calculer une intensité intermédiaire $\tilde{I}_k$, l'intensité intermédiaire $\tilde{I}_k$ étant calculée en ajoutant à l'intensité cumulée $I_k$ l'intensité intermédiaire $\tilde{I}_{k+1}$ d'une classe de hiérarchie immédiatement supérieure si une telle classe de hiérarchie immédiatement supérieure existe ; obtenir un produit cumulé $P_k$ en multipliant un carré de l'intensité intermédiaire $\tilde{I}_k$ ainsi obtenue par une valeur $d_{k,k-1}$ représentative d'une distance séparant les compteurs électriques de ladite classe *k* des compteurs électriques de la classe de niveau de hiérarchie immédiatement inférieur ou du concentrateur de données lorsque la classe *k* a le niveau de hiérarchie le plus faible ; et, obtenir l'estimation de l'énergie perdue en ligne $E_P^{c_k}$ de la classe *k* en multipliant le produit cumulé par une durée *T* de la période prédéfinie et une valeur de résistance moyenne par mètre $R_{moy}$ desdits câbles d'alimentation électrique.

Selon un mode de réalisation, l'intensité cumulée $I_k$ pour chaque classe *k* se calcule de la manière suivante :

$$I_k = \frac{1}{T}\left(\sum_{i=1}^{M_k}\left(\frac{E_{k_i}}{U_{k_i}.\cos\varphi_{k_i}}\right)\right) + M_k.\frac{C_{moy}}{U_{M_k}}$$

où $M_k$ est une quantité de compteurs électriques dans la classe *k*, $E_{k_i}$ est une énergie mesurée par un compteur électrique *i* de la classe *k* correspondant à une énergie consommée par une installation électrique supervisée par ledit compteur électrique *i* sur la période prédéfinie, $U_{k_i}$ est une tension moyenne mesurée par ledit compteur électrique *i* de la classe *k* sur la période prédéfinie en entrée de ladite installation électrique, cos $\varphi_{k_i}$ est un facteur de puissance dudit compteur électrique *i* de la classe *k*, $C_{moy}$ est une puissance moyenne consommée sur la période prédéfinie par ledit compteur électrique *i* de la classe *k* et $U_{M_k}$ est une moyenne de tensions mesurées par lesdits compteurs électriques compris dans la classe *k* sur la période prédéfinie en entrée de leurs installations électriques respectives.

Selon un mode de réalisation, l'énergie intrinsèque globale $E_I^g$ est calculée de la manière suivante :

$$E_I^g = T.S.C_{moy}$$

où S est la cardinalité de ladite pluralité de compteurs électriques.

Selon un mode de réalisation, l'énergie mesurée globale $E_M^g$ est calculée de la manière suivante :

$$E_M^g = \sum_{k=1}^{K}\sum_{i=1}^{M_k}E_{k_i}$$

où K représente une quantité de classes définies dans ledit réseau.

Selon un mode de réalisation, l'information représentative d'un éloignement transmise par au moins un desdits compteurs électriques au concentrateur de données est la tension moyenne $U_{k_i}$ mesurée par ledit compteur électrique *i* de la classe *k* sur la période prédéfinie en entrée de ladite installation électrique, et chacune desdites plages est bornée par une borne supérieure et une borne inférieure correspondant à des pourcentages prédéfinis d'une tension moyenne maximale $U_{DC}$ mesurée en entrée du réseau de fourniture d'électricité pendant la période prédéfinie.

Selon un mode de réalisation, les communications par courant porteur en ligne utilisent le protocole PRIME et l'information représentative d'un éloignement transmise par au moins un desdits compteurs électriques, dit compteur PRIME, au concentrateur de données est une valeur de niveau telle que spécifiée par le protocole PRIME correspondant à un nombre de compteurs électriques jouant un rôle de relais pour les communications par courant porteur en ligne entre les concentrateurs de données et le compteur PRIME, et chacune desdites plages est bornée par une borne supérieure et une borne inférieure correspondant à des valeurs prédéfinies de niveaux.

Selon un mode de réalisation, les communications par courant porteur en ligne utilisent le protocole G3-PLC et l'information représentative d'un éloignement transmise par au moins un desdits compteurs électriques au concentrateur de données est une valeur de coût de route telle que spécifiée par le protocole G3-PLC, et chacune desdites plages est bornée par une borne supérieure et une borne inférieure correspondant à des valeurs de coût de route prédéfinies.

Selon un deuxième aspect de l'invention, l'invention concerne un dispositif pour détecter une fraude dans un réseau de fourniture d'électricité selon la revendication 11.

Selon un mode de réalisation, le dispositif est le concentrateur de données ou un système d'information connecté au concentrateur de données par un réseau de communication.

Selon un troisième aspect de l'invention, l'invention concerne un programme d'ordinateur, comprenant des instructions pour mettre en œuvre, par un dispositif, le procédé selon le premier aspect, lorsque ledit programme est exécuté par un processeur dudit dispositif.

Selon un quatrième aspect de l'invention, l'invention concerne des moyens de stockage stockant un programme d'ordinateur comprenant des instructions pour mettre en œuvre, par un dispositif, le procédé selon le premier aspect, lorsque ledit programme est exécuté par un processeur dudit dispositif.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :

- la Fig. 1 illustre schématiquement un réseau CPL sous forme d'arbre implémenté sur un réseau de fourniture d'électricité dans lequel l'invention peut être mise en œuvre ;
- la Fig. 2 illustre schématiquement un exemple d'architecture matérielle du dispositif de traitement d'un système d'information mettant en œuvre l'invention. ;
- la Fig. 3 illustre schématiquement un procédé de détection de fraude selon l'invention ;
- la Fig. 4 illustre schématiquement un procédé d'estimation d'une énergie cumulée selon l'invention ;
- la Fig. 5 illustre schématiquement un procédé d'estimation d'une énergie perdue en ligne globale selon l'invention ; et,
- la Fig. 6 illustre schématiquement un détail du procédé d'estimation d'une énergie perdue en ligne globale selon l'invention.

L'invention est décrite par la suite dans un contexte dans lequel un réseau de fourniture d'électricité sur lequel est implémenté un réseau CPL comprend un concentrateur de données relié à une pluralité de compteurs électriques par des câbles d'alimentation électrique. Le concentrateur de données est relié à un système d'information par un réseau de communication tel que le réseau internet, le système d'information mettant en œuvre l'invention. Le système d'information peut alors déterminer si une fraude est en cours dans le réseau de fourniture d'électricité.

L'invention s'applique aussi dans un contexte plus large, lorsqu'un réseau de fourniture d'électricité sur lequel est implémenté un réseau CPL comprend une pluralité de concentrateurs de données, chaque concentrateur de données de ladite pluralité étant relié à une pluralité de compteurs électriques par des câbles d'alimentation électrique et l'ensemble des concentrateurs de données étant relié par un réseau de communication à un système d'information. On considère ici que la pluralité de compteurs électriques connectés à un concentrateur de données forme un sous réseau de fourniture d'électricité du réseau de fourniture d'électricité. Dans ce cas, le système d'information implémente l'invention et peut déterminer si une fraude est en cours dans le réseau de fourniture d'électricité. Le système d'information peut déterminer de plus dans quel sous réseau de fourniture d'électricité la fraude est mise en œuvre ce qui permet de cibler où rechercher un fraudeur.

L'invention peut aussi être implémentée par un concentrateur de données. Dans ce cas, le concentrateur de données peut rapporter au système d'information qu'une fraude est en cours dans le sous réseau de fourniture d'électricité avec lequel il est connecté.

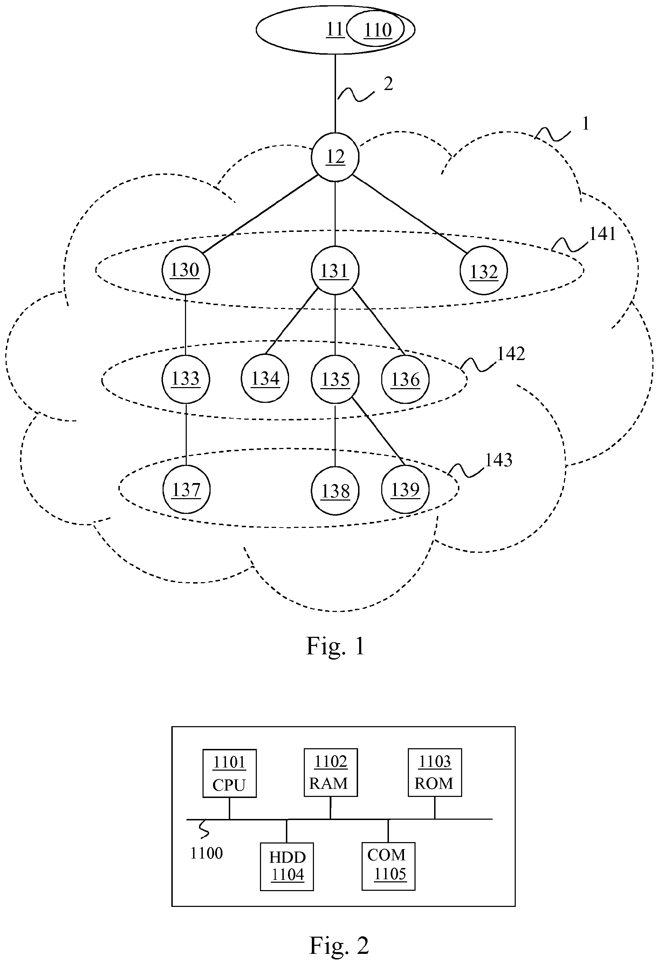

La **Fig. 1** illustre schématiquement un réseau CPL sous forme d'arbre implémenté dans un réseau de fourniture d'électricité 1 dans lequel l'invention peut être mise en œuvre.

Ledit réseau CPL comprend un concentrateur de données 12 connecté à une pluralité de compteurs électriques 130 à 139. Chaque compteur électrique supervise une installation électrique et mesure une énergie électrique consommée dans ladite installation électrique. Les compteurs électriques 130 à 132 sont reliés directement au concentrateur de données 12. Les compteurs électriques 130 et 131 servent respectivement de relai aux compteurs électriques 133 et 134 à 136. Le compteur électrique 133 sert de relai au compteur électrique 137. Le compteur électrique 139 sert de relai aux compteurs électriques 138 et 139. Les compteurs 130 à 132 n'ayant pas de compteur électrique parent (i.e. de nœud parent), ils forment un premier niveau de hiérarchie 141 correspondant au niveau de hiérarchie le plus bas.

Soit $k$ une variable représentant un niveau de hiérarchie, pour le niveau de hiérarchie le plus bas, $k=1$. Les compteurs électriques 133 à 136 utilisant un relai, ils forment un deuxième niveau de hiérarchie 142. Pour ce deuxième niveau de hiérarchie, $k=2$. Les compteurs électriques 137 à 139 utilisant deux relais, ils forment un troisième niveau de hiérarchie 143. Pour ce troisième niveau de hiérarchie, $k=3$. Le concentrateur de données 12 est relié à un système d'information 11 par un réseau de communication 2 tel que par exemple le réseau internet. Le système d'information 11 peut être connecté à d'autres réseaux CPL du même type que le réseau CPL décrit en relation avec la Fig. 1 par l'intermédiaire d'autres concentrateurs de données non représentés. Des communications CPL sont mises en œuvre dans chaque réseau CPL en utilisant le protocole PRIME, G3-PLC ou d'autres protocoles de communication CPL.

Dans un mode de réalisation, l'invention est mise en œuvre par un module de traitement 110 du système d'information 11.

Dans un mode de réalisation, l'invention est mise en œuvre par un module de traitement compris dans le concentrateur de données 12. Dans ce cas, le concentrateur de données 12 transmet des alertes de détection de fraude au système d'information 11 en cas de détection d'une fraude dans le réseau de fourniture d'électricité 1.

La **Fig. 2** illustre schématiquement un exemple d'architecture matérielle du module de traitement 110 du système d'information 11 mettant en œuvre l'invention.

Selon l'exemple d'architecture matérielle représenté à la Fig. 2, le module de traitement 110 comprend alors, reliés par un bus de communication 1100 : un processeur ou CPU (« Central Processing Unit » en anglais) 1101 ; une mémoire vive RAM (« Random Access Memory » en anglais) 1102; une mémoire morte ROM (« Read Only Memory » en anglais) 1103 ; une unité de stockage telle qu'un disque dur ou un lecteur de support de stockage, tel qu'un lecteur de cartes SD (« Secure Digital » en anglais) 1104 ; au moins une interface de communication 1105 permettant au module de traitement 110 de recevoir des informations du concentrateur de données 12, ces informations ayant été transmises au concentrateur de données 12 par les compteurs électriques 130 à 139.

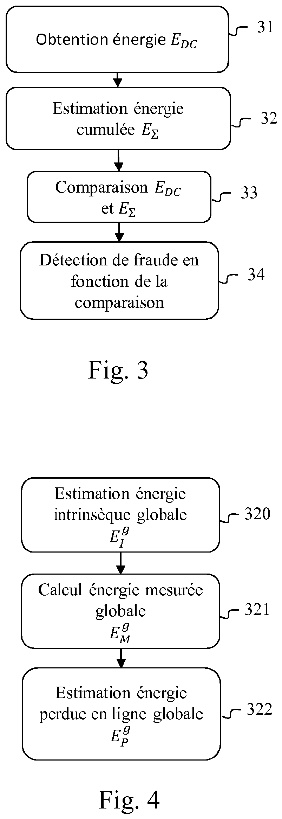

Le processeur 1101 est capable d'exécuter des instructions chargées dans la RAM 1102 à partir de la ROM 1103, d'une mémoire externe (non représentée), d'un support de stockage (tel qu'une carte SD), ou d'un réseau de communication. Lorsque le module de traitement 110 est mis sous tension, le processeur 1101 est capable de lire de la RAM 1102 des instructions et de les exécuter. Ces instructions forment un programme d'ordinateur causant la mise en œuvre, par le processeur 1101, de tout ou partie du procédé décrit ci-après en relation avec les Figs. 3 à 6.

Le procédé décrit ci-après en relation avec les Figs. 3 à 6 peut être implémenté sous forme logicielle par exécution d'un ensemble d'instructions par une machine programmable, par exemple un DSP (« Digital Signal Processor » en anglais) ou un microcontrôleur, ou être implémentées sous forme matérielle par une machine ou un composant dédié, par exemple un FPGA (« Field-Programmable Gate Array » en anglais) ou un ASIC (« Application-Specific Integrated Circuit » en anglais).

La **Fig. 3** illustre schématiquement un procédé de détection de fraudes selon l'invention mis en œuvre par le module de traitement 110.

Dans une étape 31, le module de traitement 110 du système d'information 11 obtient du concentrateur de données 12, une mesure d'une énergie globale $E_{DC}$ consommée dans le réseau de fourniture d'électricité sur une période prédéfinie. La mesure de l'énergie globale $E_{DC}$ a été mesurée par le concentrateur de données 12 en entrée du réseau de fourniture d'électricité 1. L'énergie globale $E_{DC}$ correspond aux énergies électriques effectivement consommées dans le réseau de fourniture d'électricité 1 sur la période prédéfinie, i.e. toutes les énergies consommées dans le réseau de fourniture d'électricité lui-même, par exemple du fait de pertes en ligne dans des câbles d'alimentation électrique reliant les compteurs électriques 130 à 139 au concentrateur de données 12, l'énergie consommée dans chaque compteur 130 à 139 pour son fonctionnement que nous appelons par la suite *énergie intrinsèque* du compteur, et l'énergie consommée dans les installations électriques supervisées par les compteurs électriques 130 à 139.

Dans une étape 32, le module de traitement 110 effectue une estimation d'une énergie cumulée $E_{\Sigma}$. L'énergie cumulée $E_{\Sigma}$ résulte d'une somme d'une énergie intrinsèque globale $E_I^g$ consommée sur la période prédéfinie par ladite pluralité de compteurs électriques, d'une énergie mesurée globale $E_M^g$ correspondant à une somme d'énergies mesurées respectivement par les compteurs électriques pendant la période prédéfinie et d'une énergie perdue en ligne globale $E_P^g$ représentative d'une énergie perdue dans lesdits câbles d'alimentation électrique pendant la période prédéfinie. On note que la terminologie « énergie mesurée » est synonyme de la terminologie « énergie active » couramment employée dans le domaine de l'électricité.

Dans une étape 33, le module de traitement 110 effectue une comparaison de la mesure de l'énergie globale $E_{DC}$ avec l'estimation de l'énergie cumulée $E_{\Sigma}$. Dans un mode de réalisation, le module de traitement 110 calcule un ratio $R$ correspondant à une division de l'énergie cumulée $E_{\Sigma}$ par l'énergie globale $E_{DC}$.

$$R = \frac{E_{\Sigma}}{E_{DC}}$$

Le ratio R est ensuite comparé à une valeur de seuil prédéfinie.

Dans une étape 34, le module de traitement 110 détecte une fraude en fonction d'un résultat de la comparaison. Une fraude est détectée lorsque le ratio *R* est inférieur à la valeur de seuil prédéfinie. On considère par exemple qu'un ratio inférieur à un seuil égal à 95% indique qu'une fraude est en cours dans le réseau de fourniture d'électricité 1.

La **Fig. 4** illustre schématiquement un procédé d'estimation de l'énergie cumulée $E_\Sigma$

Dans une étape 320, le module de traitement 110 estime l'énergie intrinsèque globale $E_I^g$. L'énergie intrinsèque globale $E_I^g$ correspond à une somme d'énergies intrinsèques consommées par chaque compteur électrique 130 à 139 pour son fonctionnement sur la période prédéfinie. L'énergie intrinsèque globale $E_I^g$ est calculée de la manière suivante :

$$E_I^g = T.\sum_{n=1}^{S} C_{moy} = T.S.C_{moy}$$

où *T* est une durée de la période prédéfinie, S est la cardinalité de la pluralité de compteurs électriques 130 à 139, ici *S*=10, et $C_{moy}$ est une puissance moyenne consommée sur la période prédéfinie par un compteur de ladite pluralité de compteurs électriques 130 à 139. Dans un mode de réalisation, la cardinalité S et la puissance moyenne $C_{moy}$ sont connues par le système d'information 11. Dans un mode de réalisation, la puissance moyenne $C_{moy}$ est connue du module de traitement 110.

Dans une étape 321, le module de traitement 110 calcule l'énergie mesurée globale $E_M^g$. L'énergie mesurée globale $E_M^g$ est calculée de la manière suivante :

$$E_M^g = \sum_{n=1}^{S} E_n$$

où $E_n$ est une énergie mesurée par un compteur électrique d'indice *n* de la pluralité de compteurs électriques 130 à 139. Par exemple, les compteurs électriques 130, 131, 132, 133, 134, 135, 136, 137, 138, 139 ont respectivement un indice *n* égal à 1, 2, 3, 4, 5, 6, 7, 8, 9, 10. L'énergie mesurée $E_n$ correspond à l'énergie consommée par l'installation électrique supervisée par le compteur électrique d'indice *n* et mesurée par le compteur d'indice *n*. Dans un mode de réalisation, le compteur électrique 130 (respectivement 131 à 139) transmet une information représentative de l'énergie mesurée $E_1$ ($E_n$ avec respectivement n=2 à 10) qu'il mesure au concentrateur de données 12 en utilisant des communications CPL basées, par exemple, sur le protocole PRIME ou le protocole G3-PLC. Ces informations représentatives des énergies mesurées $E_n$ sont ensuite transmises au système d'information 11 en envoyant, par exemple, des requêtes HTTP (protocole de transfert hypertexte, « HyperText Transfer Protocol » en terminologie anglo-saxonne) par le réseau de communication 2.

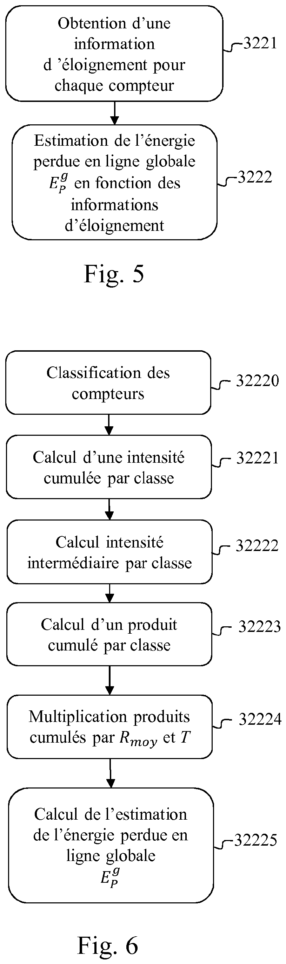

Dans une étape 322, le module de traitement 110 estime l'énergie perdue en ligne globale $E_P^g$. L'énergie perdue en ligne globale $E_P^g$ correspond à des pertes en lignes dans le réseau de fourniture d'électricité 1. Les câbles d'alimentation électrique n'ont pas une résistance nulle. La résistance des câbles d'alimentation électrique est la cause principale des pertes en lignes dans les réseaux de fourniture d'électricité. On connaît en général une résistance moyenne par mètre des câbles d'alimentation électrique, notée $R_{moy}$ par la suite. La résistance d'un câble d'alimentation électrique dépend donc d'une longueur de ce câble. Nous décrivons par la suite en relation avec les Figs. 5 et 6, un procédé d'estimation de l'énergie perdue en ligne globale $E_P^g$.

La **Fig. 5** illustre schématiquement un procédé d'estimation d'une énergie perdue en ligne globale $E_P^g$.

Dans une étape 3221, le module de traitement 110 obtient de la part de chaque compteur électrique 130 à 139, une information représentative d'un éloignement dudit compteur électrique par rapport au concentrateur de données 12.

Selon un mode de réalisation, une tension moyenne $U_n$ mesurée pendant la période prédéfinie en entrée d'un compteur électrique d'indice $n$ est une information représentative d'un éloignement dudit compteur électrique d'indice $n$ par rapport au concentrateur de données 12 lorsqu'elle est comparée à une tension maximale moyenne $U_{DC}$ mesurée en entrée du réseau de fourniture d'électricité 1 pendant la période prédéfinie. Dans ce mode de réalisation, au moins un compteur électrique parmi les compteurs électriques 130 à 139 transmet au moins une tension moyenne $U_n$ qu'il a mesurée au concentrateur de données 12 par communication CPL. Cette tension moyenne $U_n$ est ensuite transmise au système d'information 11 par exemple en utilisant une requête HTTP afin qu'il puisse déterminer l'éloignement dudit compteur.

Dans une étape 3222, le module de traitement 3222 effectue une estimation de l'énergie perdue en ligne globale $E_P^g$ en utilisant lesdites informations représentatives des éloignements selon un procédé que nous décrivons en relation avec la Fig. 6.

Dans un mode de réalisation, le protocole PRIME est utilisé pour les communications CPL entre au moins un compteur électrique d'indice $n$ parmi les compteurs électriques 130 à 139. Le protocole PRIME permet à un compteur électrique de fournir à un concentrateur de données une information représentative de son éloignement par rapport audit concentrateur de données sous forme d'un niveau de hiérarchie (« level » en terminologie anglo-saxonne). Chaque niveau de hiérarchie dépend d'un nombre de relais utilisés par le compteur électrique pour communiquer avec le concentrateur de données. Ainsi, un compteur électrique qui n'utilise aucun relai pour communiquer avec le concentrateur de données possède un niveau de hiérarchie égal à « 1 ». Le niveau de hiérarchie d'un compteur électrique est incrémenté de 1 pour chaque relai utilisé pour communiquer avec le concentrateur de données 12. Par exemple, le compteur électrique 131 possède un niveau de hiérarchie égal à « 1 », alors que le compteur électrique 138 possède un niveau de hiérarchie égal à « 3 ». Dans ce mode de réalisation, le niveau de hiérarchie d'un compteur électrique est considéré comme une information représentative d'un éloignement du compteur électrique par rapport au concentrateur de données 12. En effet, dans ce mode de réalisation, le système d'information est capable de faire un lien entre le niveau de hiérarchie d'un compteur électrique et un éloignement du compteur électrique par rapport au concentrateur de données 12. Le niveau de hiérarchie du compteur est ensuite transmis au système d'information 11 par exemple en utilisant une requête HTTP, afin qu'il puisse déterminer l'éloignement dudit compteur.

Dans un mode de réalisation, le protocole G3-PLC est utilisé pour les communications CPL entre au moins un compteur électrique d'indice $n$ parmi les compteurs électriques 130 à 139. Le protocole G3-PLC utilise une méthode de routage dans le réseau CPL basé sur une estimation de coût de route (« route cost » en terminologie anglo-saxonne). Un compteur électrique devant communiquer avec le concentrateur de données 12 doit déterminer une meilleure route dans le réseau de fourniture d'électricité 1 pour communiquer avec le concentrateur de données 12. Pour ce faire, des coûts de route sont estimés entre le compteur électrique et le concentrateur de données 12 et la route correspondant au coût de route le plus faible est choisie pour communiquer entre le compteur électrique et le concentrateur de données 12. Lors de la détermination de la meilleure route entre le compteur électrique et le concentrateur de données 12, le concentrateur de données 12 a la connaissance du coût de la meilleure route. Dans ce mode de réalisation, le coût de la meilleure route est considéré comme représentatif d'un éloignement du compteur électrique par rapport au concentrateur de données 12. En effet, dans ce mode de réalisation, le système d'information est capable de faire un lien entre le coût de la meilleure route et un éloignement du compteur électrique par rapport au concentrateur de données 12. Le coût de la meilleure route est ensuite transmis au système d'information 11, par exemple en utilisant une requête HTTP, afin qu'il puisse déterminer l'éloignement dudit compteur.

La **Fig. 6** illustre schématiquement un détail du procédé d'estimation d'une énergie perdue en ligne globale $E_P^g$ correspondant à l'étape 3222.

Dans une étape 32220, le module de traitement 110 classe chaque compteur électrique 130 à 139 dans une classe parmi un ensemble prédéfini de classes de compteurs électriques en fonction de l'information représentative de l'éloignement dudit compteur. Chacune desdites classes est associée à une plage de valeurs d'informations représentatives d'éloignements. Dans le mode de réalisation basé sur une utilisation d'une information représentative d'un éloignement sous forme d'une tension moyenne $U_n$, le module de traitement 110 calcule un ratio $\frac{U_n}{U_{DC}}$. Les bornes de chaque classe prédéfinie sont des pourcentages prédéfinis de la tension moyenne maximale $U_{DC}$. Le module de traitement 110 compare alors le ratio $\frac{U_n}{U_{DC}}$ auxdits pourcentages prédéfinis pour déterminer l'éloignement dudit compteur.

Par exemple, lorsque $97\% < \frac{U_n}{U_{DC}} \leq 100\%$ le compteur électrique est considéré comme appartenant à une classe de niveau « 1 ». Lorsque $94\% < \frac{U_n}{U_{DC}} \leq 97\%$ le compteur électrique est considéré comme appartenant à une classe de niveau « 2 ». Lorsque $90\% < \frac{U_n}{U_{DC}} \leq 94\%$ le compteur électrique est considéré comme appartenant à une classe de niveau « 3 ». Lorsque $\frac{U_n}{U_{DC}} \leq 90\%$ le compteur électrique est considéré comme appartenant à une classe de niveau « 4 ». Par la suite nous notons $k$ le niveau d'une classe, et une classe de niveau $k$ est appelée *classe k*. Tous les compteurs électriques classés dans une même classe sont considérés à la même distance du concentrateur de données 12, i.e. les compteurs électriques d'une même classe sont associés à une même valeur d'éloignement. Dans l'exemple décrit en relation avec la Fig. 1, les compteurs électriques 130 à 132 sont dans la classe « 1 », les compteurs électriques 133 à 136 sont dans la classe « 2 » et les compteurs électriques 137 à 139 sont dans la classe « 3 ».

Dans des étapes 32221 à 32223, le module de traitement 110 estime une énergie perdue en ligne $E_P^{c_k}$ pour chaque classe $k$.

Lors de l'étape 32221, le module de traitement 110 calcule une intensité cumulée $I_k$ pour la classe $k$. L'intensité cumulée $I_k$ étant une somme d'intensités moyennes de courants électriques reçus par et provenant de chaque compteur électrique de ladite classe $k$ pendant la période prédéfinie.

L'intensité cumulée $I_k$ pour chaque classe $k$ se calcule de la manière suivante :

$$I_k = \frac{1}{T}\left(\sum_{i=1}^{M_k}\left(\frac{E_{k_i}}{U_{k_i}.\cos\varphi_{k_i}}\right)\right) + M_k.\frac{C_{moy}}{U_{M_k}}$$

où $M_k$ est une quantité de compteurs électriques dans la classe $k$, $E_{k_i}$ est une énergie mesurée par un compteur électrique $i$ de la classe $k$ correspondant à l'énergie consommée par l'installation électrique supervisée par ledit compteur électrique $i$ sur la période prédéfinie, $U_{k_i}$ est une tension moyenne mesurée par ledit compteur électrique $i$ de la classe $k$ sur la période prédéfinie en entrée de ladite installation électrique, $\cos\varphi_{k_i}$ est un facteur de puissance dudit compteur électrique $i$ de la classe $k$, $C_{moy}$ est une puissance moyenne consommée sur la période prédéfinie par ledit compteur électrique $i$ de la classe $k$ et $U_{M_k}$ est une moyenne de tensions mesurées par lesdits compteurs électriques compris dans la classe $k$ sur la période prédéfinie en entrée de leurs installations électriques respectives. On remarque que l'intensité cumulée $I_k$ est une somme d'un premier terme $\frac{1}{T}\left(\sum_{i=1}^{M_k}\left(\frac{E_{k_i}}{U_{k_i}.\cos\varphi_{k_i}}\right)\right)$ et d'un second terme $M_k.\frac{C_{moy}}{U_{M_k}}$. Le premier terme correspond à une somme d'intensités moyennes de courants électriques reçus par chaque compteur électrique de la classe $k$. Le second terme correspond à une somme d'intensités moyennes de courants électriques provenant de chaque compteur électrique de la classe $k$, c'est-à-dire provenant de la consommation intrinsèque à chaque compteur électrique de la classe $k$. On note que chaque énergie mesurée $E_{k_i}$ correspond à une énergie mesurée $E_n$ mentionnée ci-dessus en relation avec l'étape 321, seuls les indices changent, l'indice $k_i$ étant une représentation par classe, $n$ étant une représentation dans la pluralité de compteurs électriques.

On pourrait donc calculer l'énergie mesurée globale $E_M^g$ de la manière suivante :

$$E_M^g = \sum_{k=1}^{K}\sum_{i=1}^{M_k} E_{k_i}$$

De manière similaire, chaque tension moyenne $U_{k_i}$ correspond à une tension moyenne $U_n$ mentionnée en relation avec l'étape 32221, seuls les indices changent, l'indice $k_i$ étant une représentation par classe, $n$ étant une représentation dans la pluralité de compteurs électriques. Le facteur de puissance $\cos\varphi_{k_i}$ est considéré connu par le système d'information 11. Le facteur de puissance cos $\varphi_{k_i}$ est mesuré par chaque compteur électrique qui le transmet au système d'information 11 via le concentrateur de données 12.

Dans l'étape 32222, le module de traitement 110 calcule une intensité intermédiaire $\tilde{I}_k$ pour chaque classe $k$. L'intensité intermédiaire $\tilde{I}_k$ est calculée en ajoutant à l'intensité cumulée $I_k$ l'intensité intermédiaire $\tilde{I}_{k+1}$ de la classe de hiérarchie immédiatement supérieure si une telle classe de hiérarchie immédiatement supérieure existe. L'intensité intermédiaire $\tilde{I}_{k+1}$ est donc calculée avant l'intensité intermédiaire $\tilde{I}_k$. Par exemple :

$$\tilde{I}_3 = I_3$$

$$\tilde{I}_2 = I_2 + \tilde{I}_3 = I_2 + I_3$$

$$\tilde{I}_1 = I_1 + \tilde{I}_2 = I_1 + I_2 + \tilde{I}_3 = I_1 + I_2 + I_3$$

Dans l'étape 32223, le module de traitement calcule pour chaque classe, un produit cumulé $P_k$ en multipliant un carré de l'intensité intermédiaire $\tilde{I}_k$ (i.e. l'intensité intermédiaire $\tilde{I}_k$ mise à la puissance « 2 ») ainsi obtenue par une valeur $d_{k,k-1}$ représentative d'une distance séparant les compteurs électriques de ladite classe $k$ des compteurs électriques de la classe $k$-1 ou du concentrateur de données 12 lorsque la classe $k$ a le niveau de hiérarchie le plus faible, i.e. lorsque $k$=1.

Par exemple :

$$P_3 = d_{3,2}.(\tilde{I}_3)^2$$

$$P_2 = d_{2,1}.(\tilde{I}_2)^2$$

$$P_1 = d_{1,0}.(\tilde{I}_1)^2$$

$d_{1,0}$ étant une distance séparant les compteurs électriques de la classe « 1 » du concentrateur de données 12.

Dans un mode de réalisation, le système d'information 11 connaît les distances $d_{k,k-1}$. Ces informations sont liées à la topologie du réseau et sont fournies par l'opérateur de fourniture d'électricité, ou déduites par un gestionnaire du réseau de fourniture d'électricité (1) d'informations fournies par l'opérateur de fourniture d'électricité.

Dans l'étape 32224, le module de traitement 110 obtient l'estimation de l'énergie perdue en ligne $E_P^{C_k}$ de la classe $k$ en multipliant le produit cumulé par une durée $T$ de la période prédéfinie et une valeur de résistance moyenne par mètre $R_{moy}$ desdits câbles d'alimentation électrique. La résistance moyenne par mètre $R_{moy}$ est connue du système d'information 11.

$$E_P^{C_k} = R_{moy}.T.P_k$$

Par exemple :

$$E_P^{c_3} = R_{moy}.T.P_3 = R_{moy}.T.d_{3,2}.(\tilde{I}_3)^{\,2}$$

$$E_P^{c_2} = R_{moy}.T.P_2 = R_{moy}.T.d_{2,1}.(\tilde{I}_2)^{2\,2}$$

$$E_P^{c_1} = R_{moy}.T.P_1 = R_{moy}.T.d_{1,0}.(\tilde{I}_1)^2$$

Dans une étape 32225, le module de traitement 110 calcule l'estimation de l'énergie perdue en ligne globale

$E_P^g$ en sommant les énergies perdues en ligne $E_P^{c_k}$ estimées pour chaque classe *k*.

$$E_P^g = \sum_{k=1}^{K} E_P^{c_k}$$

Par exemple :

$$E_P^g = E_P^{c_1} + E_P^{c_2} + E_P^{c_3}$$

Dans le mode de réalisation basé sur une utilisation du protocole PRIME pour les communications CPL entre un compteur électrique de la pluralité de compteurs électriques et le concentrateur de données 12, l'information représentative d'un éloignement est transmise sous forme d'une valeur de niveau $L_n$. Les bornes de chaque plage prédéfinie sont des valeurs de niveau prédéfinies. Le module de traitement 110 compare alors la valeur de niveau $L_n$ auxdites valeurs de niveau prédéfinies pour déterminer l'éloignement dudit compteur. Par exemple, lorsque $L_n \leq 1$ le compteur électrique est considéré comme appartenant à la classe « 1 ». Lorsque $1 < L_n \leq 3$, le compteur électrique est considéré comme appartenant à la classe « 2 ». Lorsque $3 < L_n \leq 5$, le compteur électrique est considéré comme appartenant à la classe « 3 ». Lorsque $5 < L_n$, le compteur électrique est considéré comme appartenant à la classe « 4 ».

Dans le mode de réalisation basé sur une utilisation du protocole G3-PLC pour les communications CPL entre un compteur électrique de la pluralité de compteurs électriques et le concentrateur de données 12, l'information représentative d'un éloignement est transmise sous forme d'un coût de route $CR_n$. Les bornes de chaque plage prédéfinie sont des coûts de route prédéfinis. Le module de traitement 110 compare alors la valeur de niveau $CR_n$ auxdits coûts de route prédéfinis pour déterminer l'éloignement dudit compteur. Par exemple, lorsque $CR_n \leq 20$, le compteur électrique est considéré comme appartenant à la classe « 1 ». Lorsque $20 < CR_n \leq 50$, le compteur électrique est considéré comme appartenant à la classe « 2 ». Lorsque $50 < CR_n \leq 100$, le compteur électrique est considéré comme appartenant à la classe « 3 ». Lorsque $100 < CR_n$, le compteur électrique est considéré comme appartenant à la classe « 4 ».

## Revendications

**1.** Procédé de détection de fraudes dans un réseau de fourniture d'électricité (1) comprenant une pluralité de compteurs électriques (130, 131, 132, 133, 134, 135, 136, 137, 138, 139) reliés à un concentrateur de données (12) par des câbles d'alimentation électrique, **caractérisé en ce que** le procédé comprend :

obtenir (31) une mesure d'une énergie globale $E_{DC}$ consommée dans le réseau de fourniture d'électricité sur une période prédéfinie ;
effectuer une estimation (32) d'une énergie cumulée $E_\Sigma$, l'énergie cumulée $E_\Sigma$ résultant d'une somme d'une énergie intrinsèque globale $E_I^g$ consommée sur la période prédéfinie par ladite pluralité de compteurs électriques, d'une énergie mesurée globale $E_M^g$ correspondant à une somme d'énergies mesurées respectivement par les compteurs électriques pendant la période prédéfinie et d'une énergie perdue en ligne globale $E_P^g$ représentative d'une énergie perdue dans lesdits câbles d'alimentation électrique pendant la période prédéfinie, une procédure d'estimation de l'énergie perdue en ligne globale $E_P^g$ étant implémentée et comprenant : obtenir (3221), de la part de chaque compteur électrique, une information représentative d'un éloignement dudit compteur électrique par rapport au concentrateur de données (12) ; et, effectuer une estimation (3222) de l'énergie perdue en ligne globale $E_P^g$ en utilisant lesdites informations représentatives des éloignements ; l'estimation (3222) de l'énergie perdue en ligne globale $E_P^g$ en utilisant lesdites informations représentatives des éloignements comprend :

classer (32220) chaque compteur électrique dans une classe parmi un ensemble prédéfini de classes en fonction de l'information représentative de l'éloignement dudit compteur, chaque classe étant associée à une plage de valeurs d'informations représentatives d'éloignements;

estimer (32221, 32222, 32223, 32224) une énergie perdue en ligne $E_P^{C_k}$ pour chaque classe k; et,

calculer (32225) l'estimation de l'énergie perdue en ligne globale $E_P^g$ en sommant les énergies perdues en ligne $E_P^{C_k}$ estimées pour chaque classe $k$ ;

effectuer une comparaison (33) de la mesure de l'énergie globale $E_{DC}$ avec l'estimation de l'énergie cumulée $E_\Sigma$ ; et,

détecter (34) une fraude en fonction d'un résultat de ladite comparaison.

2. Procédé selon la revendication 1 **caractérisé en ce que**, lors de la comparaison, un ratio résultant d'une division de l'énergie cumulée $E_\Sigma$ par l'énergie globale $E_{DC}$ est comparé à une valeur de seuil prédéfinie, une fraude étant détectée lorsque ledit ratio est inférieur à la valeur de seuil prédéfinie.

3. Procédé selon la revendication 1 ou 2, **caractérisé en ce que** l'énergie mesurée globale $E_M^g$ et l'énergie perdue en ligne globale $E_P^g$ sont calculées à partir d'informations transmises par lesdits compteurs électriques au concentrateur de données (12) en utilisant des communications par courant porteur en ligne via le réseau de fourniture d'électricité (1).

4. Procédé selon la revendication 1, 2 ou 3, **caractérisé en ce que** chaque classe $k$ est associée en outre à un niveau de hiérarchie, une première classe associée à une première plage ayant un niveau de hiérarchie inférieur à une deuxième classe associée à une deuxième plage lorsque la première plage est représentative d'éloignements inférieurs aux éloignement représentés par la seconde plage, et **en ce que** l'estimation de l'énergie perdue en ligne de chaque classe $k$ comprend :

calculer (32221) une intensité cumulée $I_k$ pour la classe $k$, l'intensité cumulée $I_k$ étant une somme d'intensités moyennes de courants électriques reçus par et provenant de chaque compteur électrique de ladite classe $k$ pendant la période prédéfinie ;

calculer (32222) une intensité intermédiaire $\tilde{I}_k$, l'intensité intermédiaire $\tilde{I}_k$ étant calculée en ajoutant à l'intensité cumulée $I_k$ l'intensité intermédiaire $\tilde{I}_{k+1}$ d'une classe de hiérarchie immédiatement supérieure si une telle classe de hiérarchie immédiatement supérieure existe ;

obtenir (32223) un produit cumulé $P_k$ en multipliant un carré de l'intensité intermédiaire $\tilde{I}_k$ ainsi obtenue par une valeur $d_{k,k-1}$ représentative d'une distance séparant les compteurs électriques de ladite classe $k$ des compteurs électriques de la classe de niveau de hiérarchie immédiatement inférieur ou du concentrateur de données (12) lorsque la classe $k$ a le niveau de hiérarchie le plus faible ; et,

obtenir (32224) l'estimation de l'énergie perdue en ligne $E_P^{C_k}$ de la classe $k$ en multipliant le produit cumulé par une durée $T$ de la période prédéfinie et une valeur de résistance moyenne par mètre $R_{moy}$ desdits câbles d'alimentation électrique.

5. Procédé selon la revendication 4, **caractérisé en ce que** l'intensité cumulée $I_k$ pour chaque classe $k$ se calcule de la manière suivante :

$$I_k = \frac{1}{T}\left(\sum_{i=1}^{M_k}\left(\frac{E_{k_i}}{U_{k_i}.\cos\varphi_{k_i}}\right)\right) + M_k.\frac{C_{moy}}{U_{M_k}}$$

où $M_k$ est une quantité de compteurs électriques dans la classe $k$, $E_{k_i}$ est une énergie mesurée par un compteur électrique $i$ de la classe $k$ correspondant à une énergie consommée par une installation électrique supervisée par ledit compteur électrique $i$ sur la période prédéfinie, $U_{k_i}$ est une tension moyenne mesurée par ledit compteur électrique $i$ de la classe $k$ sur la période prédéfinie en entrée de ladite installation électrique, $\cos\varphi_{k_i}$ est un facteur de puissance dudit compteur électrique $i$ de la classe $k$, $C_{moy}$ est une puissance moyenne consommée sur la période prédéfinie par ledit compteur électrique $i$ de la classe $k$ et $U_{M_k}$ est une moyenne de tensions mesurées par lesdits compteurs électriques compris dans la classe *k* sur la période prédéfinie en entrée de leurs installations électriques respectives.

6. Procédé selon la revendication 5, **caractérisé en ce que** l'énergie intrinsèque globale $E_I^g$ est calculée de la manière suivante :

$$E_I^g = T.S.C_{moy}$$

où S est la cardinalité de ladite pluralité de compteurs électriques.

7. Procédé selon la revendication 6, **caractérisé en ce que** l'énergie mesurée globale $E_M^g$ est calculée de la manière suivante :

$$E_M^g = \sum_{k=1}^{K} \sum_{i=1}^{M_k} E_{k_i}$$

où K représente une quantité de classes définies dans ledit réseau.

8. Procédé selon l'une quelconque des revendications 1 à 7, **caractérisé en ce que** l'information représentative d'un éloignement transmise par au moins un desdits compteurs électriques au concentrateur de données (12) est la tension moyenne $U_{k_i}$ mesurée par ledit compteur électrique *i* de la classe *k* sur la période prédéfinie en entrée de ladite installation électrique, et chacune desdites plages est bornée par une borne supérieure et une borne inférieure correspondant à des pourcentages prédéfinis d'une tension moyenne maximale $U_{DC}$ mesurée en entrée du réseau de fourniture d'électricité (1) pendant la période prédéfinie.

9. Procédé selon l'une quelconque des revendications 1 à 8, **caractérisé en ce que** les communications par courant porteur en ligne utilisent le protocole PRIME et l'information représentative d'un éloignement transmise par au moins un desdits compteurs électriques, dit compteur PRIME, au concentrateur de données (12) est une valeur de niveau telle que spécifiée par le protocole PRIME correspondant à un nombre de compteurs électriques jouant un rôle de relais pour les communications par courant porteur en ligne entre le concentrateurs de données (12) et le compteur PRIME, et chacune desdites plages est bornée par une borne supérieure et une borne inférieure correspondant à des valeurs prédéfinies de niveaux.

10. Procédé selon l'une quelconque des revendications 1 à 9, **caractérisé en ce que** les communications par courant porteur en ligne utilisent le protocole G3-PLC et l'information représentative d'un éloignement transmise par au moins un desdits compteurs électriques au concentrateur de données (12) est une valeur de coût de route telle que spécifiée par le protocole G3-PLC, et chacune desdites plages est bornée par une borne supérieure et une borne inférieure correspondant à des valeurs de coût de route prédéfinies.

11. Dispositif pour détecter une fraude dans un réseau de fourniture d'électricité (1) comprenant une pluralité de compteurs électriques (130, 131, 132, 133, 134, 135, 136, 137, 138, 139) reliés à un concentrateur de données (12) par des câbles d'alimentation électrique, **caractérisé en ce que** le dispositif comprend :

des moyens d'obtention (110, 31) pour obtenir une mesure d'une énergie globale $E_{DC}$ consommée dans le réseau de fourniture d'électricité (1) sur une période prédéfinie ;

des moyens d'estimation (110, 32) pour effectuer une estimation d'une énergie cumulée $E_{\Sigma}$, l'énergie cumulée $E_{\Sigma}$ résultant d'une somme d'une énergie intrinsèque globale $E_I^g$ consommée sur la période prédéfinie par ladite pluralité de compteurs électriques, d'une énergie mesurée globale $E_M^g$ correspondant à une somme d'énergies mesurées respectivement par les compteurs électriques pendant la période prédéfinie et d'une énergie perdue en ligne globale $E_P^g$ représentative d'une énergie perdue dans lesdits câbles d'alimentation électrique pendant la période prédéfinie, des moyens d'estimation (110, 322) de l'énergie perdue en ligne globale $E_P^g$ étant utilisés et comprenant : des moyens d'obtention (110, 3221) pour obtenir, de la part de chaque compteur électrique, une information représentative d'un éloignement dudit compteur électrique par rapport au concentrateur de données (12) ; et, des moyens d'estimation (110, 3222) pour estimer l'énergie perdue en ligne globale $E_P^g$ en utilisant lesdites informations représentatives des éloignements ; lesdits moyens d'estimation (110, 3222) pour estimer l'énergie perdue en ligne globale $E_P^g$ comprenant des moyens de classification (110, 32220) pour classer chaque compteur électrique dans une classe parmi un ensemble prédéfini de classes en fonction de l'information représentative de l'éloignement dudit compteur, chaque classe étant associée à une plage de valeurs d'informations représentatives d'éloignements;

des moyens d'estimation (110, 32221, 32222, 32223, 32224) pour estimer une énergie perdue en ligne $E_P^{c_k}$ pour chaque classe $k$; et,

des moyens de calcul (110, 32225) pour calculer l'estimation de l'énergie perdue en ligne globale $E_P^g$ en sommant les énergies perdues en ligne $E_P^{c_k}$ estimées pour chaque classe $k$ ;

des moyens de comparaison (110, 33) pour comparer la mesure de l'énergie globale $E_{DC}$ avec l'estimation de l'énergie cumulée $E_\Sigma$ ; et,

des moyens de détection (110, 34) pour détecter une fraude en fonction d'un résultat de ladite comparaison.

**12.** Dispositif selon la revendication 11, **caractérisé en ce que** le dispositif est le concentrateur de données (12) ou un système d'information (11) connecté au concentrateur de données (12) par un réseau de communication (2).

**13.** Programme d'ordinateur, **caractérisé en ce qu'**il comprend des instructions pour mettre en œuvre, par un dispositif (11, 12) selon la revendication 11 ou 12, le procédé selon l'une quelconque des revendications 1 à 10, lorsque ledit programme est exécuté par un processeur (1101) dudit dispositif (11, 12).

**14.** Moyens de stockage, **caractérisés en ce qu'**ils stockent un programme d'ordinateur comprenant des instructions pour mettre en œuvre, par un dispositif (11, 12) selon la revendication 11 ou 12, le procédé selon l'une quelconque des revendications 1 à 10, lorsque ledit programme est exécuté par un processeur (1101) dudit dispositif (11, 12).

**Patentansprüche**

**1.** Verfahren zur Erkennung von betrügerischen Handlungen in einem Stromversorgungsnetz (1), umfassend eine Vielzahl von Stromzählern (130, 131, 132, 133, 134, 135, 136, 137, 138, 139), die über elektrische Versorgungskabel mit einem Datenkonzentrator (12) verbunden sind, **dadurch gekennzeichnet, dass** das Verfahren umfasst:

Erhalten (31) einer Messung einer Gesamtenergie $E_{DC}$, die im Stromversorgungsnetz über einen vorgegebenen Zeitraum verbraucht wird;

Durchführen einer Schätzung (32) einer kumulierten Energie $E_\Sigma$, wobei sich die kumulierte Energie $E_\Sigma$ aus einer Summe einer intrinsischen Gesamtenergie $E_I^g$, die über den vorgegebenen Zeitraum durch die Vielzahl von Stromzählern verbraucht wird, einer gemessenen Gesamtenergie $E_M^g$, die einer Summe von Energien entspricht, die während des vorgegebenen Zeitraums jeweils durch die Stromzähler gemessen werden, und einer Gesamtleitungsverlustenergie $E_P^g$, die eine Verlustenergie darstellt, die während des vorgegebenen Zeitraums in den elektrischen Versorgungskabeln verloren geht, ergibt, wobei ein Verfahren zur Schätzung der Gesamtleitungsverlustenergie $E_P^g$ umgesetzt wird und umfasst: Erhalten (3221) einer Information, die eine Entfernung des Stromzählers zum Datenkonzentrator (12) darstellt, von jedem Stromzähler; und Durchführen einer Schätzung (3222) der Gesamtleitungsverlustenergie $E_P^g$ anhand der Informationen, die die Entfernungen darstellen; wobei die Schätzung (3222) der Gesamtleitungsverlustenergie $E_P^g$ anhand der Informationen, die die Entfernungen darstellen, umfasst:

Einordnen (32220) jedes Stromzählers in eine Klasse unter einer vorgegebenen Gruppe von Klassen in Abhängigkeit von der Information, die die Entfernung des Zählers darstellt, wobei jede Klasse einem Wertebereich der Informationen, die Entfernungen darstellen, zugeordnet ist;

Schätzen (32221, 32222, 32223, 32224) einer Leitungsverlustenergie $E_P^{c_k}$ für jede Klasse k; und

Berechnen (32225) der Schätzung der Gesamtleitungsverlustenergie $E_P^g$ durch Summieren der Leitungsverlustenergien $E_P^{c_k}$, die für jede Klasse $k$ geschätzt wurden;
Durchführen eines Vergleichs (33) der Messung der Gesamtenergie $E_{DC}$ mit der Schätzung der kumulierten Energie $E_\Sigma$; und
Erkennen (34) einer betrügerischen Handlung in Abhängigkeit von einem Ergebnis des Vergleichs.

2. Verfahren nach Anspruch 1, **dadurch gekennzeichnet, dass** bei dem Vergleich ein Verhältnis, das sich durch eine Division der kumulierten Energie $E_\Sigma$ durch die Gesamtenergie $E_{DC}$ ergibt, mit einem vorgegebenen Schwellenwert verglichen wird, wobei eine betrügerische Handlung erkannt wird, wenn das Verhältnis kleiner als der vorgegebene Schwellenwert ist.

3. Verfahren nach Anspruch 1 oder 2, **dadurch gekennzeichnet, dass** die gemessene Gesamtenergie $E_M^g$ und die Gesamtleitungsverlustenergie $E_P^g$ auf der Grundlage von Informationen berechnet werden, die durch die Stromzähler an den Datenkonzentrator (12) übertragen werden, indem Mitteilungen über Leitungsträgerstrom über das Stromversorgungsnetz (1) verwendet werden.

4. Verfahren nach Anspruch 1, 2 oder 3, **dadurch gekennzeichnet, dass** jede Klasse k einer Hierarchieebene zugeordnet ist, wobei eine erste Klasse einem ersten Bereich zugeordnet ist, der eine Hierarchieebene aufweist, die unter einer zweiten Klasse liegt, die einem zweiten Bereich zugeordnet ist, wenn der erste Bereich Entfernungen darstellt, die kleiner sind als die Entfernungen, die von dem zweiten Bereich dargestellt werden, und dass die Schätzung der Leistungsverlustenergie jeder Klasse $k$ umfasst:

Berechnen (32221) einer kumulierten Stärke $I_k$ für die Klasse $k$, wobei die kumulierte Stärke $I_k$ eine Summe von mittleren Stärken elektrischer Ströme ist, die von jedem Stromzähler der Klasse $k$ während eines vorgegebenen Zeitraums empfangen und abgegeben werden;
Berechnen (32222) einer mittleren Stärke $\tilde{I}_k$, wobei die mittlere Stärke $\tilde{I}_k$ berechnet wird, indem der kumulierten Stärke $I_k$ die mittlere Stärke $\tilde{I}_{k+1}$ einer unmittelbar höheren Hierarchieklasse hinzugefügt wird, wenn eine solche unmittelbar höhere Hierarchieklasse existiert;
Erhalten (32223) eines kumulierten Produkts $P_k$ durch Multiplizieren eines Quadrats der so erhaltenen mittleren Stärke $\tilde{I}_k$ mit einem Wert $d_{k,k-1}$, der eine Distanz darstellt, die die Stromzähler der Klasse $k$ von den Stromzählern der unmittelbar niedrigeren Hierarchieebene oder dem Datenkonzentrator (12) trennt, wenn die Klasse $k$ die niedrigste Hierarchieebene einnimmt; und

Erhalten (32224) der Schätzung der Leitungsverlustenergie $E_P^{c_k}$ der Klasse $k$ durch Multiplizieren des kumulierten Produkts mit einer Dauer $T$ des vorgegebenen Zeitraums und einem Wert des mittleren Widerstands pro Meter $R_{moy}$ der elektrischen Versorgungskabel.

5. Verfahren nach Anspruch 4, **dadurch gekennzeichnet, dass** die kumulierte Stärke $I_k$ für jede Klasse k auf folgende Weise berechnet wird:

$$I_k = \frac{1}{T}\left(\sum_{i=1}^{M_k}\left(\frac{E_{k_i}}{U_{k_i} \cdot cos\,\varphi_{k_i}}\right)\right) + M_k \cdot \frac{C_{moy}}{U_{M_k}}$$

wobei $M_k$ eine Menge von Stromzählern in der Klasse $k$ ist, $E_{k_i}$ eine Energie ist, die von einem Stromzähler $i$ der Klasse $k$ gemessen wird und einer Energie entspricht, die von einer von dem Stromzähler $i$ überwachten Elektroanlage über den vorgegebenen Zeitraum verbraucht wird, $U_{ki}$ eine mittlere Spannung ist, die am Eingang der Elektroanlage von dem Stromzähler $i$ der Klasse $k$ über den vorgegebenen Zeitraum gemessen wird, $cos\varphi_{k_i}$ ein Leistungsfaktor des Stromzählers $i$ der Klasse $k$ ist, $C_{moy}$ eine mittlere Leistung ist, die über den vorgegebenen Zeitraum durch den Stromzähler $i$ der Klasse $k$ verbraucht wird, und $U_{M_k}$ ein Mittelwert von Spannungen ist, die durch die in der Klasse k umfassten Stromzähler über den vorgegebenen Zeitraum am Eingang ihrer jeweiligen Elektroanlagen gemessen werden.

6. Verfahren nach Anspruch 5, **dadurch gekennzeichnet, dass** die intrinsische Gesamtenergie $E_I^g$ auf die folgende Weise berechnet wird:

$$E_I^g = T.S.C_{moy}$$

wobei $S$ die Kardinalität der Vielzahl von Stromzählern ist.

7. Verfahren nach Anspruch 6, **dadurch gekennzeichnet, dass** die gemessene Gesamtenergie $E_M^g$ auf folgende Weise berechnet wird:

$$E_M^g = \sum_{k=1}^{K} \sum_{i=1}^{M_k} E_{k_i}$$

wobei K eine Menge vorgegebener Klassen im Netz darstellt.

8. Verfahren nach einem der Ansprüche 1 bis 7, **dadurch gekennzeichnet, dass** die Information, die eine Entfernung darstellt und durch mindestens einen der Stromzähler an den Datenkonzentrator (12) übertragen wird, die mittlere Spannung $U_{ki}$ ist, die vom Stromzähler $i$ der Klasse $k$ über einen vorgegebenen Zeitraum am Eingang der Elektroanlage gemessen wird, und jeder der Bereiche durch eine Obergrenze und eine Untergrenze begrenzt ist, die vorgegebenen Prozentsätzen einer maximalen mittleren Spannung $U_{DC}$ entsprechen, die am Eingang des Stromversorgungsnetzes (1) während des vorgegebenen Zeitraums gemessen wird.

9. Verfahren nach einem der Ansprüche 1 bis 8, **dadurch gekennzeichnet, dass** die Mitteilungen über Leitungsträgerstrom das Protokoll PRIME nutzen und die Information, die eine Entfernung darstellt und durch mindestens einen der Stromzähler, PRIME-Stromzähler genannt, an den Datenkonzentrator (12) übertragen wird, ein Pegelwert ist, wie er durch das Protokoll PRIME spezifiziert ist und einer Anzahl von Stromzählern entspricht, die eine Rolle als Relais für die Mitteilungen über Leitungsträgerstrom zwischen den Datenkonzentratoren (12) und dem PRIME-Zähler spielen, und jeder der Bereiche durch eine Obergrenze und eine Untergrenze begrenzt ist, die vorgegebenen Pegelwerten entsprechen.

10. Verfahren nach einem der Ansprüche 1 bis 9, **dadurch gekennzeichnet, dass** die Mitteilungen über Leitungsträgerstrom das Protokoll G3-PLC nutzen und die Information, die eine Entfernung darstellt und durch mindestens einen der Stromzähler an den Datenkonzentrator (12) übertragen wird, ein Streckenkostenwert ist, wie er durch das Protokoll G3-PLC spezifiziert ist, und jeder der Bereiche durch eine Obergrenze und eine Untergrenze begrenzt ist, die vorgegebenen Streckenkostenwerten entsprechen.

11. Vorrichtung zur Erkennung von betrügerischen Handlungen in einem Stromversorgungsnetz (1), umfassend eine Vielzahl von Stromzählern (130, 131, 132, 133, 134, 135, 136, 137, 138, 139), die über elektrische Versorgungskabel mit einem Datenkonzentrator (12) verbunden sind, **dadurch gekennzeichnet, dass** die Vorrichtung umfasst:

Mittel zum Erhalt (110, 31) zum Erhalten einer Messung einer Gesamtenergie $E_{DC}$, die im Stromversorgungsnetz (1) über einen vorgegebenen Zeitraum verbraucht wird;

Mittel zur Schätzung (110, 32) zum Durchführen einer Schätzung einer kumulierten Energie $E_\Sigma$, wobei sich die

kumulierte Energie $E_\Sigma$ aus einer Summe einer intrinsischen Gesamtenergie $E_I^g$, die über den vorgegebenen Zeitraum durch die Vielzahl von Stromzählern verbraucht wird, einer gemessenen Gesamtenergie $E_M^g$, die einer Summe von Energien entspricht, die während des vorgegebenen Zeitraums jeweils durch die Stromzähler gemessen werden, und einer Gesamtleitungsverlustenergie $E_P^g$, die eine Verlustenergie darstellt, die während des vorgegebenen Zeitraums in den elektrischen Versorgungskabeln verloren geht, ergibt, wobei Mittel zur Schätzung (110, 322) der Gesamtleitungsverlustenergie $E_P^g$ verwendet werden und umfassen: Mittel zum Erhalt (110, 3221) zum Erhalten einer Information, die eine Entfernung des Stromzählers zum Datenkonzentrator (12) darstellt, von jedem Stromzähler; und Mittel zur Schätzung (110, 3222) zum Schätzen der Gesamtleitungsverlustenergie $E_P^g$ anhand der Informationen, die die Entfernungen darstellen; wobei die Mittel zur Schätzung (110, 3222) zum Schätzen der Gesamtleitungsverlustenergie $E_P^g$ Mittel zur Einordnung (110, 32220) zum Einordnen jedes Stromzählers in eine Klasse unter einer vorgegebenen Gruppe von Klassen in Abhängigkeit von der Information, die die Entfernung des Zählers darstellt, umfasst, wobei jede Klasse einem Wertebereich der Informationen, die Entfernungen darstellen, zugeordnet ist;

Mittel zur Schätzung (110, 32221, 32222, 32223, 32224) zum Schätzen einer Leitungsverlustenergie $E_P^{c_k}$ für jede Klasse $k$; und

Mittel zur Berechnung (110, 32225) zum Berechnen der Schätzung der Gesamtleitungsverlustenergie $E_P^g$ durch Summieren der Leitungsverlustenergien $E_P^{c_k}$, die für jede Klasse $k$ geschätzt wurden;
Mittel zum Vergleich (110, 33) zum Vergleichen der Messung der Gesamtenergie $E_{DC}$ mit der Schätzung der kumulierten Energie $E_\Sigma$; und
Mittel zur Erkennung (110, 34) zum Erkennen einer betrügerischen Handlung in Abhängigkeit von einem Ergebnis des Vergleichs.

12. Vorrichtung nach Anspruch 11, **dadurch gekennzeichnet, dass** die Vorrichtung der Datenkonzentrator (12) oder ein Informationssystem (11) ist, das über ein Kommunikationsnetz (2) mit dem Datenkonzentrator (12) verbunden ist.

13. Computerprogramm, **dadurch gekennzeichnet, dass** es Anweisungen zur Durchführung des Verfahrens nach einem der Ansprüche 1 bis 10 durch eine Vorrichtung (11, 12) nach Anspruch 11 oder 12 umfasst, wenn das Programm durch einen Prozessor (1101) der Vorrichtung (11, 12) ausgeführt wird.

14. Speichermittel, **dadurch gekennzeichnet, dass** sie ein Computerprogramm speichern, das Anweisungen zur Durchführung des Verfahrens nach einem der Ansprüche 1 bis 10 durch eine Vorrichtung (11, 12) nach Anspruch 11 oder 12 umfasst, wenn das Programm durch einen Prozessor (1101) der Vorrichtung (11, 12) ausgeführt wird.

**Claims**

1. Method for detecting frauds in an electricity supply network (1) comprising a plurality of electricity meters (130, 131, 132, 133, 134, 135, 136, 137, 138, 139) connected to a data concentrator (12) by electricity supply cables, **characterised in that** the method comprises:

obtaining (31) a measurement of global energy $E_{DC}$ consumed in the electricity supply network over a predefined period;

making an estimation (32) of total energy $E_\Sigma$, the total energy $E_\Sigma$ resulting from the sum of a global intrinsic energy $E_I^g$ consumed over the predefined period by said plurality of electricity meters, a global measured energy $E_M^g$ corresponding to a sum of energies measured respectively by the electricity meters during the predefined period and the global wire-loss energy $E_P^g$ representing energy lost in said electricity supply cables during the predefined period, a procedure for estimating the global wire-loss energy $E_P^g$ being implemented and comprising: obtaining (3221), from each electricity meter, information representing a distance of said electricity meter with respect to the data concentrator (12); and making an estimation (3222) of the global wire-loss energy $E_P^g$ using said information representing distances;

making a comparison (33) of the measurement of the global energy $E_{DC}$ with the estimation of the total energy $E_{\Sigma}$; and

detecting (34) fraud according to a result of said comparison, wherein

the estimation (3222) of the global wire-loss energy $E_P^g$ using said information representing distances comprises:

classifying (32220) each electricity meter in a class from a predefined set of classes according to the information representing the distance of said meter, each class being associated with a range of information values representing distances;

estimating (32221, 32222, 32223, 32224) a wire-loss energy $E_P^{c_k}$ for each class $k$; and

calculating (32225) the estimation of the global wire-loss energy $E_P^g$ by adding the wire-loss energies $E_P^{c_k}$ estimated for each class $k$.

2. Method according to claim 1, **characterised in that**, during the comparison, a ratio resulting from a division of the total energy $E_{\Sigma}$ by the global energy $E_{DC}$ is compared with a predefined threshold value, a fraud being detected when said ratio is less than the predefined threshold value.

3. Method according to claim 1 or 2, **characterised in that** the global measured energy $E_M^g$ and the global wire-loss energy $E_P^g$ are calculated from information transmitted by said electricity meters to the data concentrator (12) using power line communications via the electricity supply network (1).

4. Method according to claim 1, 2 or 3, **characterised in that** each class $k$ is further associated with a hierarchy level, a first class associated with a first range having a hierarchy level lower than a second class associated with a second range when the first range represents distances less than the distances represented by the second range, and **in that** the estimation of the wire-loss energy of each class $k$ comprises:

calculating (32221) a total intensity $I_k$ for the class $k$, the total intensity $I_k$ being a sum of mean intensities of electrical currents received by and coming from each electricity meter in said class $k$ during the predefined period; calculating (32222) an intermediate intensity $\tilde{I}_k$, the intermediate intensity $\tilde{I}_k$ being calculated by adding to the total intensity $I_k$ the intermediate intensity $\tilde{I}_{k+1}$ of a hierarchy class immediately higher if such an immediately higher hierarchy class exists; obtaining (32223) a total product $P_k$ by multiplying a square of the intermediate intensity $\tilde{I}_k$ thus obtained by a value $d_{k,k-1}$ representing a distance separating the electricity meters in said class $k$ from the electricity meters in the class with a hierarchy level immediately lower or of the data concentrator when the class $k$ has a lowest hierarchy level; and

obtaining (32224) the estimation of the wire-loss energy $E_P^{c_k}$ of the class $k$ by multiplying the total product by a duration $T$ of the predefined period and a mean resistance value per metre $R_{moy}$ of said electricity supply cables.

5. Method according to claim 4, **characterised in that** the total intensity $I_k$ for each class k is calculated as follows:

$$I_k = \frac{1}{T}\left(\sum_{i=1}^{M_k}\left(\frac{E_{k_i}}{U_{k_i}.\cos\varphi_{k_i}}\right)\right) + M_k.\frac{C_{moy}}{U_{M_k}}$$

where $M_k$ is a quantity of electricity meters in the class $k$, $E_{k_i}$ is an energy measured by an electricity meter $i$ in the class $k$ corresponding to an energy consumed by an electrical installation supervised by said electricity meter $i$ over the predefined period, $U_{k_i}$ is a mean voltage measured by said electricity meter $i$ in class $k$ over a predefined period at the input to said electrical installation, cos $\varphi_{k_i}$ is a power factor of said electricity meter $i$ in the class $k$, $C_{moy}$ is a mean power consumed over the predefined period by said electricity meter $i$ in the class $k$, and $U_{M_k}$ is a mean of voltages measured by said electricity meters included in the class k over the predefined period at the input to their respective electrical installations.

6. Method according to claim 5, **characterised in that** the global intrinsic energy $E_I^g$ is calculated in the following manner:

$$E_I^g = T.S.C_{moy}$$

where S is the cardinality of said plurality of electricity meters.

7. Method according to claim 6, **characterised in that** the global measured energy $E_M^g$ is calculated as follows:

$$E_M^g = \sum_{k=1}^{K}\sum_{i=1}^{M_k} E_{k_i}$$

where K represents a quantity of classes defined in said network.

8. Method according to any one of claims 1 to 7, **characterised in that** the information representing a distance transmitted by at least one of said electricity meters to the data concentrator (12) is the mean voltage $U_{k_i}$ measured by said electricity meter $i$ in the class $k$ over the predefined period at the input to said electrical installation, and each of said ranges is delimited by an upper bound and a lower bound corresponding to predefined percentages of a maximum mean voltage $U_{DC}$ measured at the input of the electricity supply network (1) during the predefined period.

9. Method according to any one of claims 1 to 8, **characterised in that** the power line communications use the PRIME protocol and the information representing a distance transmitted by at least one of said electricity meters, referred to as a PRIME meter, to the data concentrator (12) is a level as specified by the prime protocol corresponding to a number of electricity meters fulfilling the role of relay for the power line communications between the data concentrators (12) he PRIME meter, and each of said ranges is delimited by an upper bound and a lower bound corresponding to predefined level values.

10. Method according to any one of claims 1 to 9, **characterised in that** the power line communications use the G3-PLC protocol and the information representing a distance transmitted by at least one of said electricity meters to the data concentrator (12) is a route cost value as specified by the G3-PLC protocol, and each of said ranges is delimited by an upper bound and a lower bound corresponding to predefined route cost values.

11. Device for detecting fraud in an electricity supply network (1) comprising a plurality of electricity meters (130, 131, 132, 133, 134, 135, 136, 137, 138, 139) connected to a data concentrator (12) by electricity supply cables, **characterised in that** the device comprises:

obtaining means (110, 31) for obtaining a measurement of a global energy $E_{DC}$ consumed in the electricity supply network (1) over a predefined period;

estimation means (110, 32) for estimating a total energy $E_\Sigma$, the total energy $E_\Sigma$ resulting from the sum of a global intrinsic energy $E_I^g$ consumed over the predefined period by said plurality of electricity meters, a global measured energy $E_M^g$ corresponding to a sum of energies measured respectively by the electricity meters during the predefined period and a global wire-loss energy $E_P^g$ representing an energy lost in said electricity supply cables during the predefined period, means for estimating (110, 322) the global loss line energy $E_P^g$ being used and comprising: obtaining means (110, 3221) for obtaining, from each electricity meter, information representing a distance of said electricity meter with respect to the data concentrator (12); and estimation means (110, 3222) for estimating the global wire-loss energy $E_P^g$ using said information representing distances;

wherein, the estimation means (110, 3222) for estimating the global wire-loss energy $E_P^g$ comprising:

classification means for classifying (110, 32220) each electricity meter in a class from a predefined set of classes according to the information representing the distance of said meter, each class being associated with a range of information values representing distances;

estimation means for estimating (110, 32221, 32222, 32223, 32224) a wire-loss energy $E_P^{c_k}$ for each class $k$; and

calculation means for calculating (110, 32225) the estimation of the global wire-loss energy $E_P^g$ by adding the wire-loss energies $E_P^{c_k}$ estimated for each class $k$

comparison means (110, 33) for comparing the measurement of the global energy $E_{DC}$ with the estimation of the total energy $E_\Sigma$; and

detection means (110, 34) for detecting fraud according to a result of said comparison.

12. Device according to claim 11, **characterised in that** the device is the data concentrator (12) or an information system (11) connected to the data concentrator (12) by a communication network (2).

13. Computer program, **characterised in that** it comprises instructions for the implementation, by a device (11, 12) according to claim 11 or 12, of the method according to any one of claims 1 to 10, when said program is executed by a processor (1101) of said device (11, 12).

14. Storage means, **characterised in that** they store a computer program comprising instructions for the implementation, by a device (11, 12) according to claim 11 or 12, of the method according to any one of claims 1 to 10, when said program is executed by a processor (1101) of said device (11, 12).

Fig. 1

Fig. 2

Fig. 3

Fig. 4

Obtention d'une
information
d'éloignement pour
chaque compteur — 3221

Estimation de l'énergie
perdue en ligne globale
$E_P^g$ en fonction des
informations
d'éloignement — 3222

## Fig. 5

Classification des
compteurs — 32220

Calcul d'une intensité
cumulée par classe — 32221

Calcul intensité
intermédiaire par classe — 32222

Calcul d'un produit
cumulé par classe — 32223

Multiplication produits
cumulés par $R_{moy}$ et $T$ — 32224

Calcul de l'estimation
de l'énergie perdue en
ligne globale
$E_P^g$ — 32225

## Fig. 6

**EP 3 081 949 B1**

**RÉFÉRENCES CITÉES DANS LA DESCRIPTION**

**Documents brevets cités dans la description**

- WO 2014129058 A1
- WO 2006044035 A2
- US 2010134089 A1

**Littérature non-brevet citée dans la description**

- A statistical method to minimize electrical energy losses in a local electricity distribution network. **FOURIE J W et al.** AFRICON, 2004. 7TH AFRICON CONFERENCE IN AFRICA GABORONE, BOTSWANA. IEEE, 15 Septembre 2004, vol. 2, 667-673